# EUROPEAN PATENT APPLICATION

(11) **EP 3 079 166 A1**
(43) Date of publication of application: **12.10.2016**
(21) Application number: 16164529.6
(22) Date of filing: 08.04.2016
(51) Int. Cl.: H01L 21/673, H01L 21/677

(54) **WAFER BOAT LOADER ASSEMBLY, FURNACE SYSTEM, USE THEREOF AND METHOD FOR OPERATING SAID ASSEMBLY**

(30) Priority: 09.04.2015 NL 2014606
(71) Applicant: Tempress IP B.V., 8171 MD Vaassen (NL)
(72) Inventor: Kolk, Barteld, 7908 LC Hoogeveen (NL)
(74) Representative: Nollen, Maarten Dirk-Johan

(57) **Abstract**

The wafer boat loader assembly (2) for loading wafer boats (32) into and unloading wafer boats (32) from a furnace chamber comprises an elongated guide, a carriage, a paddle and a displacement drive (8,18) and a lifting drive (14). The carriage is configured to move along the guide when driven. The paddle (31) comprises a handle part (28) and a load zone part for carrying a wafer boat (32). The displacement drive (8,18) is configured for moving the carriage along the guide (4) and the lifting drive (14) is configured for tilting the guide (4). Under the load of the wafer boat (32) the paddle (31) will bend through, but this bending may be compensated by means of the drives (8, 18), so that the wafer boat (32) can be placed into the furnace chamber in a horizontal position. Particularly, the use of merely a lifting drive (14) and a displacement drive (8,18) enables that electromotors thereof are heat shielded.

## Description

### Field of the invention

The invention relates to a wafer boat loader assembly for loading wafer boats into and unloading wafer boats from a furnace chamber. The invention further relates to a furnace system for wafers, comprising at least one furnace chamber having an end for inserting wafer boats and an associated wafer boat loader assembly according to the invention for each of said at least one furnace chamber. The invention further relates to the use of the wafer boat loader assembly for loading and unloading wafer boats into and from a furnace chamber of a furnace system, which is particularly of the horizontal type. The invention also relates to a method for operating the wafer boat loader assembly according to the invention. The invention further relates to a paddle for a wafer boat. The wafer boat loader and the furnace system are particularly envisaged for use in the manufacture of solar cells.

### Background of the invention

For the production of semiconductor devices such as integrated circuits or photovoltaic cells, wafers are subjected to a number of processing steps. These processing steps include processing in a high temperature furnace system. For example, the furnace system is used for diffusion, annealing, thermal oxidation or deposition such as chemical vapour deposition (CVD), such as atmospheric pressure CVD, vacuum CVD or plasma enhanced CVD. The wafers are introduced in the processing tubes of the furnace system, also known as furnace chamber. To this end, the wafers are placed on a wafer boat. A wafer boat can carry a number of wafers. For processes at atmospheric pressure the wafers are in general arranged parallel to each other on the wafer boat, with small intermediate distances from each other. For example, the wafer boats for atmospheric pressure processes may be provided from quartz. For high volume production of photovoltaic cells at atmospheric pressure, the wafer boats are commonly made of quartz or silicon carbide. In another example, wafer boats comprise graphite and/or ceramic components. For example, for plasma enhanced CVD the wafer boats may be provided inter alia from thin graphite plates, graphite nuts, ceramic rods and spacers.

The wafer boat is transported into the processing tube by means of a wafer boat loader. For furnace system having a horizontal processing tube, the wafer boats are transported horizontally into and out from the processing tube. Horizontal furnace systems are typically used for processing of photovoltaic cells, i.e. solar cells.

A wafer boat loader for a horizontal furnace system typically includes a carriage movable horizontally towards and away from the processing tube of the furnace system. A paddle is mounted to the carriage, forming a cantilevered support, wherein the wafer boats are positioned on the free end of the paddle. In order for the wafer boat loader to be able to load and unload the wafer boats from the paddle automatically the carriage includes a mechanism for vertical displacement of the paddle. Vertical displacement of the wafer boat allows vertically landing the boat from the cantilevered paddle onto the bottom wall of the furnace chamber. Sliding contact of the boat with the walls of the furnace chamber is thereby avoided, to minimize generation of contaminating particles and to avoid breakage of the boat or damage to the processing tube. This type of wafer boat loader is therefore also called a soft landing wafer boat loader.

US 4721424 describes a loading station including a plurality of soft landing boat loader assemblies for loading semiconductor wafer carrying boats into a furnace process tube. The boat loader assemblies are disposed in a vertically aligned, spaced relationship to each other. Each boat loader comprises a cantilevered paddle that is mounted on a carriage which is driven along guide ways by a cogged timing belt driven by a DC servo motor. The paddle is supported on the carriage by a pivotal plate which may be vertically pivoted by an eccentric cam shaft driven by a DC motor. The DC motor is connected to a controller via a flat ribbon cable which is trained around a pair of rollers and threaded through a cable take-up assembly.

A drawback of the boat loader of US 4721424 is that several heat sensitive components are exposed to a high temperature when the carriage is moved close to the processing tube when operated at a high temperature. Examples of such components are electrical parts, electronics, cables, drive components, linear guides and motors, for instance the electromotor for tilting the paddle. The exposure to heat reduces the lifetime of the motor. Moreover, the accuracy of the motor may deteriorate. An accurate positioning of a wafer boat loader is however necessary to successfully load and unload the wafer boats from the paddle.

The exposure to heat is furthermore enhanced in advanced furnace systems that have been recently introduced and contain four, five or potentially more levels on top of each other. Such advanced furnace system is particularly of a horizontal type and comprises several furnace chambers and corresponding wafer loaders on top of each other. The upper loaders, sometimes with wafer boats thereon, also experience heat from the unloaded wafer boats at the lower wafer loaders. In fact, the loaders are arranged in vertical direction straight above and between the process tubes.

Moreover, in advanced solar cell processing, it is desired to increase the number of wafers that is loaded onto a paddle at once. In contrast with the processing of integrated circuits, the economics of solar cell industry demand that many wafers are processed simultaneously. Commercially available wafer boat loader assemblies for CVD systems allow the loading of wafer boats with 250 wafers. However, it is desirable that the number of wafers on a single boat is further increased to at least 400, more preferably 500 or more, for instance 1000 wafers. Wafer boats with 1500 wafers are envisaged for the near future. This trend is foreseen to continue.

The large load applied to the free end of the paddle causes the paddle to bend. Therefore, to be able to process large loads of solar cells, the height of the processing tube needs to be adapted to accommodate the bended paddle. However, increasing the height of the processing tube is disadvantageous for the energy and process gas efficiency of the processing. This is particularly relevant since a tube is often cylindrical, such that an increase in the height implies an increase in the diameter and overall dimensions.

### Summary of the invention

A goal of the invention is to overcome or at least reduce the above problems and to provide an improved wafer boat loader, in particular a wafer boat loader less prone to heat induced damage and which enables energy and process gas efficient processing of wafer boats carrying a large load.

According to an embodiment of the present invention, a wafer boat loader assembly is provided for loading wafer boats into and unloading wafer boats from a furnace chamber, in particular a horizontal furnace chamber. The assembly comprises:
- an elongated guide which is tiltable about a horizontal rotation axis;
- a carriage coupled to the guide and configured to move along the guide when driven, and provided with a frame;
- a paddle mounted to the carriage via the frame, the paddle forming a cantilevered support comprising a proximal handle part and a distal load zone part for carrying a wafer boat, the handle part of the paddle being mounted to the frame of the carriage, the paddle extending parallel to the guide;
- a displacement drive configured for moving the carriage along the guide; and
- a lifting drive connected to the guide and configured for tilting the guide by lifting a distal end thereof relative to a proximal end thereof.

The invention is based on the insight that tilting of the guide to which the paddle is coupled, at least partially compensates for bending of the paddle in its loaded state. In particular, in solar cell production a large number of wafers may be loaded on a single wafer boat, e.g. 500-1000 wafers. This relatively heavy load on the end part of the paddle, results in bending of the paddle. However, as the wafer boat is lifted vertically by tilting the guide, the tilting angle of the wafer boat with respect to the horizontal plane is reduced. Therefore, a smaller height is needed in the processing tube to accommodate the wafer boat. The height of the processing tube and heating element can therefore be kept small, i.e. the area of the open end of the tube can be kept small. This reduces radial heat loss of the smaller heating element and reduces heatless via the open end of the processing tube. This is in particular relevant when the guide has only a single degree of freedom, i.e. when only the angle of the guide with respect to the horizontal plane can be changed. Therefore, the invention enables energy efficient processing of large loads.

Particularly, in accordance with one embodiment of the invention, this bending of the paddle is not counteracted by the use of a highly stiffened double-walled paddle, but rather in that the paddle is arranged adjacent to the tiltable guide, and that a carriage is provided configured for resisting torque of the paddle relative to the guide. While extending parallel to the guide in an unloaded state, the bending and the upward tilting in the loaded state will result in a relatively small tilting of the wafer boat with respect to the horizontal plane upon insertion into a processing tube. It has been understood that the hot environment of the processing tube is not problematic therefore, but may rather be beneficial for a smooth landing of the wafer boat. The heavy load and the high temperature tend to give rise to a higher degree of bending. The ability of reducing the tilting angle in the course of landing of the wafer boat onto a bottom wall of the processing tube allows to reduce the load on the paddle, and therewith facilitates withdrawal of the paddle from the processing tube.

In accordance with one embodiment of the invention, the carriage comprises a guide block arranged on a guide shaft. Suitably, the driving of the carriage is embodied with a second shaft, i.e. a drive shaft that is part of the displacement drive. The carriage then further comprises a driving nut that cooperates with the drive shaft. The use of two separate shafts is a stable mechanism under the operating temperatures. Preferably, the carriage is further provided with a guide holding part and extending to and/or arranged at an opposed side of the guide. The guide holding part is suitably configured as a roller guide. Alternatively or more particularly, the guide comprises a beam that is provided on a first side with a rail or groove and on a second opposed side with a guide shaft. The guide holding part suitably comprises a holding means in complementary shape to the rail or groove on the first side.
More particularly, the carriage is provided with a frame that extends transversally to the guide. The frame may extend from the guide holding part to the paddle, be formed as one piece with the guide holding part, but could alternatively be separately manufactured and assembled to the guide holding part and/or any other part of the carriage. The frame is for instance embodied as a plurality of rods. Suitably, the frame is provided with some holding means for holding a handle part of the paddle in a fixed manner. Various holding means are known per se, such as clamps, hooks, rings, locks, and covers that are fixed to the frame, for instance by means of screws. In one preferred implementation, use is made of a first and a second ring arranged behind each other such that the handle part can extend through both the first and the second ring.

One major advantage of the invention relates to heat management. Typical temperatures inside the processing tubes range from 400 °C up to 900 °C or even higher. Heat management is thus a major issue, so as to prevent thermal shocks and ensure a sufficient lifetime of any electronic components used. Preferably, the operating temperature of electronic components is kept below about 70-80 °C to ensure reliable operation. This applies in particular to any electromotors used as part of the drives. As the lifting drive is not travelling with the carriage as in prior art wafer boat loaders, the lifting drive experiences less heat from the processing chamber. Therefore, early failure of the lifting drive or associated electronic components is prevented. Furthermore, the lifting drive may be more effectively shielded from the heat of the furnace chamber. This shielding is preferably embodied with one or more heat shielding walls that extend between the paddle and the guide. By arranging the sensitive components such as the electromotors on the guide, they may be shielded by the heat shielding wall. Therewith, the lifetime of the motor is increased, reducing down time of the system. Moreover, the accuracy of the lifting drive may remain more stable over time.

Moreover, as no lifting drive has to be provided in the carriage itself, the overall complexity of the overall drive mechanism is reduced. For example, as no drive is provided in the carriage, no power cable has to be provided to the moving carriage, obviating the need for provisions for taking up a power cable. Moreover, in conventional systems for processing large loads, a rigid gearbox with high reduction ratio needs to be included in the carriage in order to be able to lift the paddle in a controlled manner. In contrast, no gearbox is required in the carriage of the assembly according to the invention.

For example, the guide may for example comprise a guide rail or guiding shaft, along which the carriage may travel.

For example, the guide may be connected to a joint, e.g. comprising a hinge or a shaft, for effecting the tilting about the horizontal axis.

Preferably, the assembly only comprises the displacement drive and the lifting drive for effecting horizontal and vertical movement, i.e. no further drives are provided. In particular, the assembly preferably includes no more than two motors.

Preferably, the horizontal rotation axis has a fixed position. In other words, the assembly is preferably configured to only allow rotation of the guide, whereas translational movement is prevented. In such an embodiment, the guide has only a single degree of freedom, namely tilting, i.e. pivoting, about the horizontal rotation axis.
Preferably, the horizontal rotation axis is provided at the proximal end of the guide.

The invention may for example be used with horizontal furnace systems for the production of semiconductor devices, in particular solar cells. However, the processing of micro-electromechanical systems (MEMS) or any other semiconductor or thin film device such as bulk acoustic wave filters, is not excluded. In particular, the invention is suitable for handling wafer boats carrying a relatively large load, e.g. a wafer boat carrying 500 or more wafers per wafer boat, in particular for processing of solar cells.

In an embodiment, the paddle is mounted to the carriage via a frame which provides a horizontal spacing between the paddle and the guide, and the wafer boat loader assembly further comprises a heat shielding wall which extends along the guide and is horizontally positioned between the guide and the paddle.

The paddle extends parallel to the guide, i.e. in the direction of horizontal movement of the carriage. The frame spaces the paddle apart from the guide and therefore from the carriage. The shielding wall is provided in the spacing between the guide and the paddle. Therefore, the guide and the carriage are at least partially shielded from the heat of the furnace chamber to which the paddle is exposed. Moreover, as the displacement drive and the lifting drive may be provided at the same side of the shielding wall as the guide and the carriage, the wall may also shield the drives of the assembly from the heat of the furnace chamber. This is in particular relevant in view of the sensitivity of motor.

For example, a part of the frame may extend under the heat shielding wall.
The heat shielding wall may for example be a metal wall, such as a steel wall. However, other materials may be used as well.

For example, the paddle may be constructed of a ceramic, such as silicon carbide or alumina. Such a material has a good heat stability as needed for insertion into a furnace chamber.

In an embodiment, a proximal end of the guide opposite the distal end comprises a joint connecting the guide to a fixed support, thus blocking translational movement of the horizontal rotation axis.

In this embodiment, the guide has only a single degree of freedom for movement, namely tilting about the joint.

In an embodiment, the guide comprises a beam and a guiding shaft, the carriage being coupled to the guiding shaft for movement along the guiding shaft. Preferably, the beam has a proximal end rotatable about a rotation shaft and a distal free end connected to the lifting drive for lifting thereof.

Preferably, the carriage is configured such that rotation about the guiding shaft is prevented.

In an embodiment, rotation about the guiding shaft is prevented by coupling the carriage to the beam via a roller guide.

In an embodiment, the displacement drive comprises a linear drive nut provided on a driver shaft, the linear drive nut being connected to the carriage.

Use of a linear drive nut, e.g. a rolling ring linear drive, has the advantage that no lubrication is necessary, preventing contamination of the furnace system. Moreover, use of a linear drive nut on a driver shaft effects a smooth travel of the carriage along the guide, in contrast to for example displacing the carriage using a timing belt.

All wafers are sensitive to vibrations. Vibrations of semiconductor wafers generated undesired (deposition) particles. Solar wafer are fragile and may break under vibration due to their very small thickness, typically less than 200 µm or even less than 100 µm. Moreover, in plasma enhanced CVD vibrations may cause solar wafers to fall out of the graphite boat due to the limited retaining and support in this application. A drawback of using a timing belt as in the prior art is that vibrations occur when moving the carriage due to the presence of cogs and gears. In contrast, a linear drive nut enables a smooth displacement of the carriage, reducing undesired vibrations.
In an embodiment, the lifting drive is configured to enable both a positive tilting angle as a negative tilting angle with respect to the horizontal plane.

In an embodiment, the paddle of the wafer boat assembly is a single-walled paddle having a load zone, wherein a cross sectional profile of the load zone comprises a central supporting section defining a channel, each opposing side of which adjoins a substantially vertical section, wherein a substantially horizontally extending flange is formed on the bottom end of each of said substantially vertical sections.

In the context of the invention, the horizontal and vertical directions are defined in relation to a horizontal orientation of the paddle, i.e. its longitudinal axis extending horizontally.

Typically, paddles for wafer boats comprise a handle part formed as an elongated structure, e.g. a solid beam. The handle part connects to a load zone, the load zone showing a cross sectional profile defining a channel adapted for carrying wafer boats and/or wafers. In general, a transitional part may connect the handle part with the load zone.

In the embodiment described above, the load zone has a shape such that in lateral direction opposing sides of the central supporting section each adjoin a substantially vertical section having a substantially horizontal flange at its bottom end. Providing the flange at the bottom ends of said substantially vertical sections, increases the resistance of the paddle against bending. The flange of each substantially vertical section acts like the flange of an I-beam, thereby increasing the bending stiffness of the paddle.

In a further preferred embodiment, the central supporting section comprises two side walls of the channel, each side wall adjoining a substantially horizontal upper wall, wherein each of said upper walls adjoins a corresponding one of said substantially vertical sections. In other words, each side wall of the channel transitions into a substantially horizontal upper wall, wherein each upper wall transitions into the substantially vertical section. Therefore, the cross sectional profile shows an angle of 90 degrees between the horizontal upper walls and the adjoining substantially vertical section.

For example, the side walls may be connected directly to each other, defining a substantially V-shaped channel. In another example, the side walls are connected to each other via a central horizontal section.
According to an embodiment of the present invention, a furnace system for wafers comprises at least one furnace chamber having an open end for inserting wafer boats, and for each of said at least one furnace chamber an associated wafer boat loader assembly according to any preceding claim.

In particular, the at least one furnace chamber is horizontally orientated, i.e. a horizontal processing tube. Two or more furnace chambers may be vertically stacked above one another, i.e. vertically arranged above one another, wherein a spacing is provided between the chambers. The furnace system comprises a wafer boat loader assembly for each of the furnace chambers. Therefore, the wafer boat loader assemblies may likewise be arranged vertically aligned above one and other.

According to an embodiment of the present invention, the wafer boat loader assembly as described above is used for loading and unloading a wafer boat into and from a furnace chamber of a furnace system.

According to an embodiment of the present invention, a method for operating a wafer boat loader assembly of the furnace system described above comprises:
- controlling the lifting drive for bringing the paddle in a horizontal position;
- loading a wafer boat onto the paddle;
- controlling the lifting drive for increasing the tilting angle of the paddle, thereby lifting the wafer boat;
- controlling the displacement drive for moving the paddle with the wafer boat into the corresponding furnace chamber;
- controlling the lifting drive for decreasing the tilting angle of the paddle, thereby lowering the wafer boat onto the bottom of the furnace chamber; and
- controlling the displacement drive for moving the paddle out of the furnace chamber.

Controlling the lifting drive for lifting the wafer boat and controlling the displacement drive for moving the paddle horizontally may be partially or completely be effected simultaneously or consecutively. Likewise, lowering the wafer boat may be effected consecutively to horizontal movement of the paddle or at least partially simultaneously.

In an embodiment of the paddle for a wafer boat according to the invention, the paddle is a single-walled paddle having a load zone, wherein a cross sectional profile of the load zone comprises a central supporting section defining a channel, each opposing side of which adjoins a substantially vertical section, wherein a substantially horizontally extending flange is formed on the bottom end of each of said substantially vertical sections. Preferably, the central supporting section comprises two side walls of the channel, each side wall adjoining a substantially horizontal upper wall, wherein each of said substantially horizontal upper walls adjoins a corresponding one of said substantially vertical sections.

### Brief introduction to the figures

These and other aspects of the invention will be further elucidated with reference to the figures, in which:
- Figure 1 shows in isometric view a wafer boat loader assembly according to an embodiment of the present invention, for clarity of illustration, the heat shielding wall of the assembly has been omitted in figure 1;
- Figure 2 shows a number of wafer boat loader assemblies according to the embodiment of figure 1 arranged above each other, wherein further the heat shielding walls of the assemblies have been illustrated;
- Figure 3 shows a front view of the assembly of figures 1 and 2;
- Figure 4A-F shows schematically different stages of movement of a wafer boat loader according to an embodiment of the present invention; and
- Figures 5A-C show a paddle according to an embodiment of the invention, wherein 5A shows an isometric view of the paddle, 5B shows a cross sectional view of a load zone of the paddle and 5C shows a front view of a handle part of the paddle.

### Detailed description of illustrated embodiments

The figures are not drawn to scale and merely diagrammatical in nature. Equal reference numerals in different figures refer to identical or corresponding features.

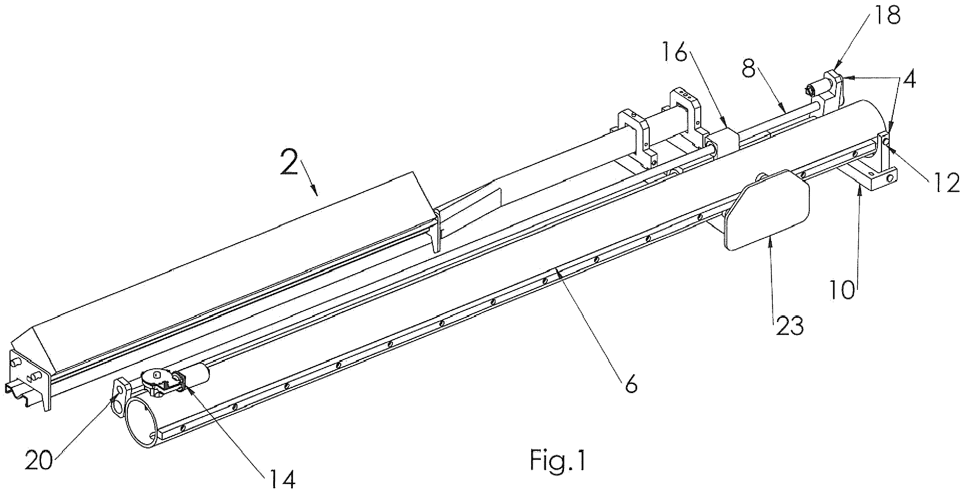

Fig. 1 shows a wafer boat loader assembly 2. In a most general sense, the wafer boat loader assembly comprises a guide 4, a carriage, a paddle, and drives for the carriage and for lifting the guide. The carriage is movable along the guide 4. The paddle is connected to the carriage, and is thus also movable along the guide, but also beyond the guide 4, so as to transport a wafer boat into a furnace chamber. The construction is such that the paddle does not overlie the guide. As a consequence, the paddle may bend through. According to the invention, the wafer boat loader assembly is arranged such that a wafer boat may be inserted into a furnace chamber and be removed from a furnace chamber by means of two drives only. Thereto, use is made of the bending through of the paddle under the weight of a wafer boat, and especially a wafer boat for a high number of solar cell wafers, such as at least 500 wafers. Typically, in these applications, the paddle itself has for instance a weight of 5-15 kg, for instance about 10 kg, whereas a wafer boat may have a weight of 20-30 kg. More particularly, by lifting a distal end of the guide, the guide is oriented upwards. Therewith also the paddle is oriented upwards. The bending through under the carried weight of a wafer boat therewith brings the distal end of the paddle into an orientation that can be controlled to be close to horizontal. It has been understood by the inventors that in this manner, the wafer boat may be loaded into and unloaded from the furnace chamber in a controlled way, particularly without major vibrations of the paddle under the load of the wafer boat, and suitably almost entirely horizontal. Outside the furnace chamber, the orientation of the boat during movement may also deviate from the horizontal orientation.

In the embodiment shown in Fig. 1, the guide comprises a beam 6 and a linear drive shaft 8. However, the invention is not limited thereto. For example, guide 4 may be provided as a guide track or rails. In the example shown, beam 6 is provided in the form of a tube, which has the advantage of being a light structure having a high strength. A proximal end of beam 6 is connected to a fixed support 10 via a rotation shaft 12, allowing the opposing distal end to be displaced vertically by rotation of beam 6 about shaft 12. In this example, the horizontal rotation axis of the guide 4 coincides with the longitudinal axis of shaft 12. In the example shown, the beam 6 has a larger diameter than the linear drive shaft 8.

The free distal end of beam 6 comprises a lifting drive 14 for displacing the distal end vertically. Alternatively, lifting drive 14 may be provided closer to the proximal end, e.g. centrally along the length of the beam 6.

As support 10 has a fixed position, beam 6 has a single degree of freedom, in the form of rotation. Alternatively, the assembly may comprise a drive for translational movement of the proximal end of beam 6, in particular vertical movement. For example, instead of only providing drive 14 at the distal end of the beam 6, a further drive may be provided at the proximal end of the beam 6.

A linear drive nut 16 is provided for movement along linear drive shaft 8. The shaft 8 is rotated using electromotor 18. The outer end of guiding shaft 8 is suspended by means of a bearing 20. In the example shown, shaft 8 and electromotor 18 together form the displacement drive of assembly 2. It cooperates with the carriage via the linear drive nut 16. However, according to the invention the displacement drive may be embodied differently.

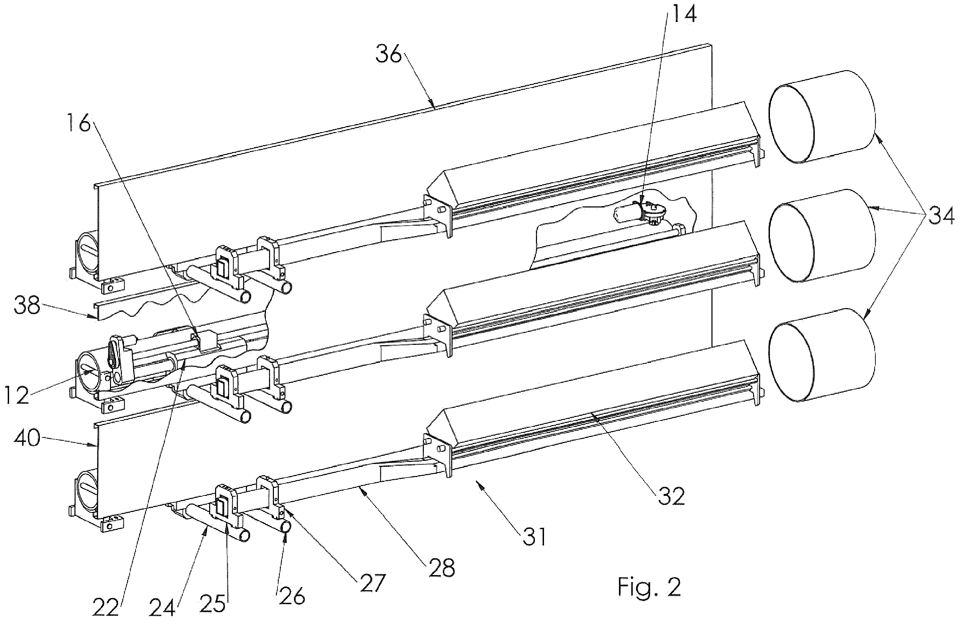

Figure 2 shows that the linear drive nut 16 is connected to a guide block 22. Therewith a carriage is formed that is moveable along guide 4. Guide block 22 is suspended on guiding shaft 19 via a through hole in block 22. The block 22 is further suspended on beam 6 via a guiding roller 23 disposed on an opposing side of the beam 6 than the guide shaft 8 (figure 1), thereby preventing rotation of block 22 about the guiding shaft 19 due to the weight of the wafer boat when in a loaded state. In the example shown, linear drive nut is a rolling ring drive. The beam 6 may be provided with a rail to which the roller guide 23 is coupled, as shown in figure 1. Generally speaking, the carriage is the element that forms the movable connection between the guide and the paddle. In the shown embodiment, it is formed by the guide block 22, the linear drive nut 16 as well as the roller guide 23 and the frame 24, 26. A different configuration is not excluded.

The use of a linear drive nut enables a smooth horizontal displacement of the carriage, in contrast to conventional systems wherein cogged timing belts are used. Therefore, vibrations are reduced, which reduces the chance of undesired deposition of particle and reduces the chance of breaking the wafers. Although the use of a linear drive nut is advantageous, alternatively other linear drives may be provided for horizontal displacement of the carriage.

Figure 2 shows further a frame 24, 26 that extends from the guide block 22 in a transversal direction. In the example shown, the frame comprises rods 24, 26. Mounted to the frame is a paddle 31 for carrying a wafer boat 32, which has only been illustrated schematically in the drawings. It is noted that paddle 31 can have any desired shape. Many different paddle shapes are known to the skilled person. A proximal part of the paddle 30 forms a handle 28, while a distal part of the paddle 30 forms a load zone for carrying wafer boat 32. The handle part 28 may be shaped as a rod, e.g. having a circular, square or rectangular cross section. The paddle 30 may be solid or hollow. A bracket 25, 27 is mounted to each of the rods 24, 26 of the frame. The brackets 25, 27 each comprise a hole for receiving handle part 28 of paddle 30. In the implementation shown in Fig. 2, the brackets 25, 27 are arranged behind each other in the axial direction of the guide 4 and the paddle 31. As a consequence, the handle part 28 of the paddle 31 is inserted through both brackets 25, 27. Hence, the weight of the paddle 31 is distributed over both rods 24, 26 of the frame. Though not shown, the handle part 28 of the paddle 31 is typically provided with stop means, so as to prevent that the handle part would move out of at least one of the brackets 25, 27. Furthermore, the proximal end of the paddle 31 may extend to the other side of the frame over a predefined distance. Rather than as a frame with two single rods 24, 26 and brackets 25, 27 mounted to each of them separately, the frame may contain more rows of rods with brackets. Furthermore, the frame may be embodied as a grid, for instance a structure with bars between the rods. The brackets may further have legs or the like for clamping around the rods rather than mounting on the rods. The brackets and rods may also be manufactured as a single monolithic element. Rather than individual brackets, use could be made of a tube section. Alternatively, paddle 30 may be mounted to the frame in a different manner.

In an advanced furnace system, multiple furnace chambers 34 are vertically stacked above one another, wherein the chambers 34 are vertically space apart. A wafer boat loader assembly 2 is provided for each of the furnace chambers 34, as schematically shown in Figure 2. Each assembly 2 is aligned laterally with a horizontal furnace chamber 34 such that the wafer boat 32 can be loaded into the chamber 34 and unloaded therefrom. However, the assembly 2 may be in its rest position at a lower level than the corresponding chamber 34. The paddle 31 is moved horizontally with respect to the furnace chamber 34 by moving the carriage 16, 22 along the guide 4 by controlling displacement drive 18. The paddle 31 is moved vertically with respect to the furnace chamber 34 by tilting guide 4 using lift drive 14.

Therefore, no lifting drive needs to be included in the carriage 16, 22 for tilting paddle 31. Instead, the lifting drive 14 is attached to the guide 4. Therefore, the lifting drive 14 experience less heat than the corresponding drives in conventional systems. This increases the lifetime of the drive 14 and prevents deterioration of accuracy. Moreover, as the lifting drive 14 does not travel with the carriage 16, 22, no provisions are required for feeding a power cable to the moving carriage.

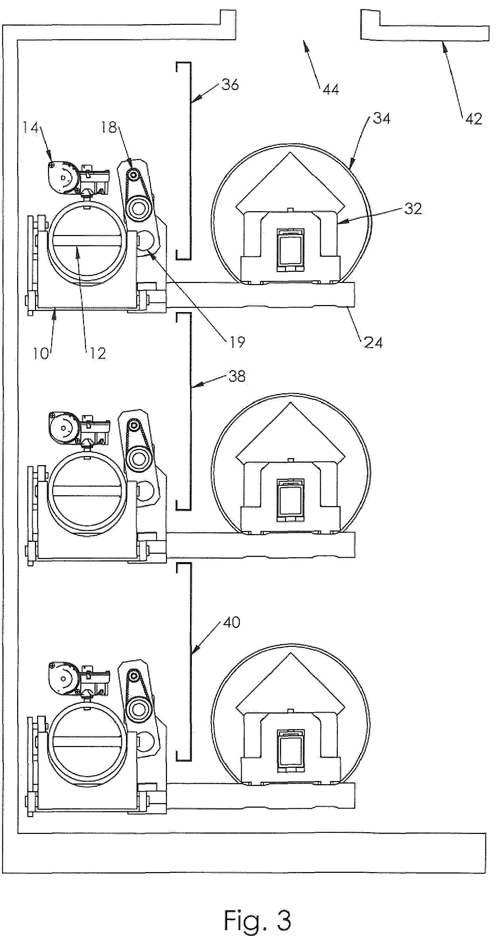

The frame 24, 26 positions the paddle 31 at a distance from the carriage 16, 22. Each of the assemblies comprises a heat shielding wall 36, 38, 40 (figures 2, 3), positioned in the space thus created. In figure 2, heat shielding wall 38 has been partially cut away for illustrating the carriage 16,22.

In each assembly, frame 24, 26 is mounted to a lower side of the carriage and extends under corresponding wall 36, 38, 40. Walls 36, 38, 40 shield the guide 4, the drives 14, 18 and the carriage 16, 22 from heat of the furnace chamber 34. Therefore, moving parts and other parts sensitive to heat are exposed to less heat. The paddle 31 is made of a heat-resistant material, such as silicon carbide, and is able to withstand the heat of furnace chamber 34.

A spacing is provided between the vertically stacked heat shielding walls 36, 38, 40. This enables the frame 24, 26 to extend underneath the corresponding wall. The spacing between the walls is dimensioned to allow tilting the paddle 30. In the example shown, a tilting angle of about 1-3 degrees can be accommodated. Alternatively, the walls 36, 38, 40 may be provided as a single wall, wherein openings are provided to allow passage of the frame 24, 26 through the wall.

An air flow may be provided in the load compartment of a furnace system according to an embodiment of the invention. Preferably, an air inlet is positioned on the same side of the heat shielding walls 36, 38, 40 as the guide 4, 6. Air will flow through the spacings between the walls to the other side of the walls. By providing the air inlet on the side of the guide 4,6 the temperature experienced by drives 14, 16 is further reduced.

The wafer boat loader assemblies 2 are provided in a housing 42 (figure 3) of a furnace system. The housing 42 comprises an exhaust 44 for hot air.

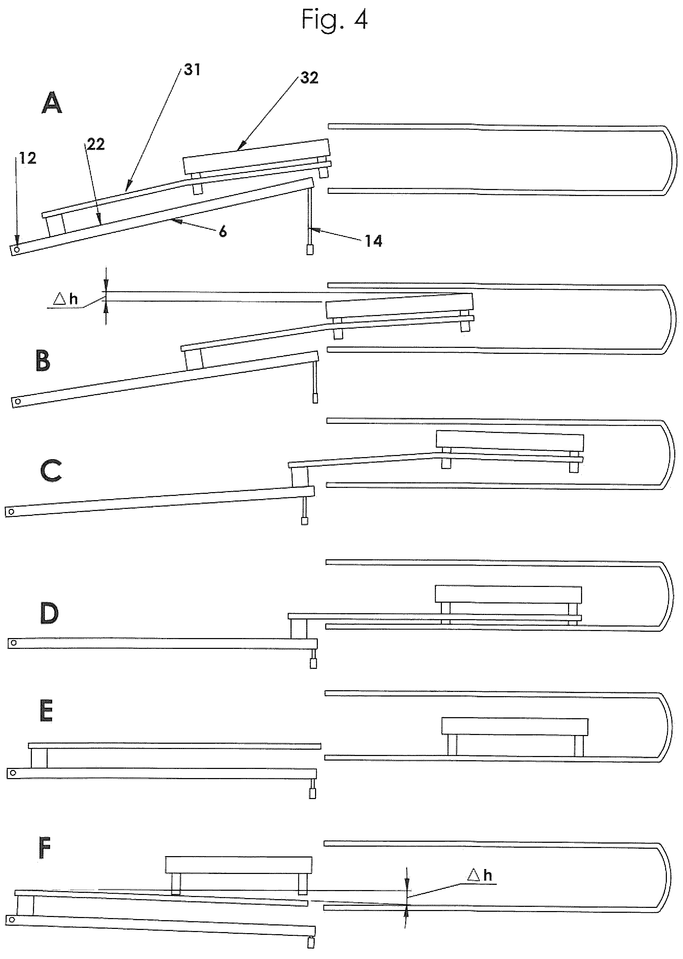

An embodiment of a method for operating a wafer boat loader assembly of a furnace system is described next with reference to figures 4A-F. When a wafer boat 32 is loaded onto the paddle 31, the lifting drive 14 is controlled for tilting the guide shaft 6, as schematically illustrated in figure 4A. As shown, the lifting drive 14 may comprise a vertically shaft, wherein the distal end of the guide may be moved with respect to the vertical shaft using e.g. a servomotor. For example, the shaft may comprises a worm gear or a linear gear rack. Simultaneously or consecutively, the guide block 22 is moved along the guide shaft 6 for moving the wafer boat 32 in the furnace chamber 34 (figure 4B). When loaded with a wafer boat 32 the paddle 30 will show a slight bend, e.g. with a deflection angle of 0,1 - 1 degrees. Therefore, the tilting angle of the wafer boat 32 with respect to the horizontal plane is slightly less than the tilting angle of the loader 2, thereby reducing the height necessary to accommodate wafer boat 32 in the chamber 34.

Subsequently, the wafer boat 32 is moved further into the chamber 34 and subsequently or simultaneously the lifting drive 14 is controlled to lower the wafer boat 32, as shown in figure 4C. During the last part of the descent of the wafer boat 32 onto the bottom of chamber 34 the drives 14, 18 are controlled to move the wafer boat 32 vertically only, at least substantially vertically only. In this manner, by control of both drives, the orientation of the wafer boat is kept substantially horizontal. It can be seen in the figures that thereto not merely the lifting drive is lowered, but that also the paddle is moved backwards slightly after a forward movement into the furnace chamber. For example, only lifting drive 14 is controlled for lowering the wafer boat 32. After soft landing of the wafer boat 32, the paddle is further lowered, such as shown in figure 4D. Then, the paddle 31 is retracted from chamber 34 by horizontally displacing the guide block 22 over the guide, while the tilting angle is kept small (figure 4E).

Figure 4F illustrates that optionally the guide may be tilted to a negative tilting angle with respect to the horizontal, i.e. the guide may be moved to a position wherein the distal end of the guide is lower than the position of a proximal end of the guide. This is advantageous for automatic loading of wafer boats onto the paddle 31. Particularly, sweeping of the paddle downwards under the weight of the wafer boat may be counteracted by such lowering, and subsequent lifting of the guide and paddle with the lifting drive.
It is noted that figure 4 highly exaggerates the vertical displacement of the carrier and the bending of the paddle, for illustrating purposes. Figure 4 is not drawn to scale.

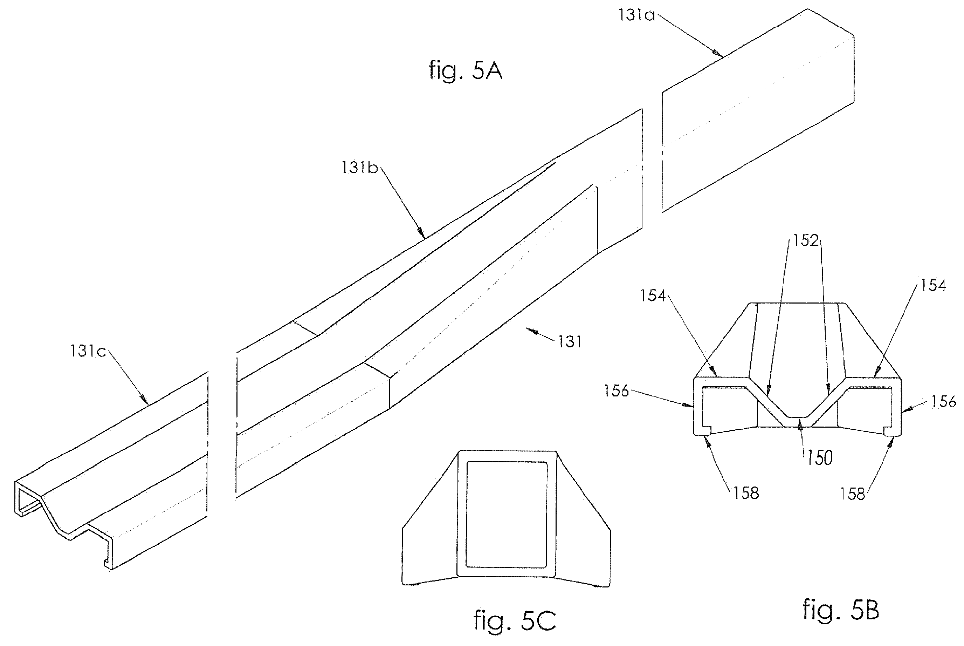

A paddle 131 (figure 5A) comprises a handle part 131a, which adjoins a transition part 131b, the transition part 131b adjoining a load zone 131c. In the example shown, the handle part 131a is formed as an elongated beam having a substantially rectangular cross section. The handle part 131a may be solid or hollow. Paddle 131 is for example made of silicon carbide or alumina.

Load zone 131c has a cross sectional profile as shown in figure 5B. The profile comprises a central horizontal wall 150. Each lateral side of the horizontal section adjoins an oblique channel wall 152. Each of the two channel walls adjoins an upper horizontal wall 154. The walls 154 provide a flat upper surface of the load zone 131c. The central horizontal wall 150, the side walls 152 and the upper horizontal walls 154 form a central supporting section of the paddle, which define a channel for carrying a wafer boat and/or wafers. The upper horizontal walls 154 may be said to each form a shoulder of the paddle shape.

The upper horizontal walls 154 each adjoin a corresponding vertical section 156 at an angle of 90 degrees. At the bottom end of the vertical section 156 a flange 158 is provided that extends horizontally, i.e. at an angle of 90 with respect to the vertical section 156.

A front view of the handle part 131a shows that the handle may have a rectangular cross section and may be formed as a tube, i.e. hollow. Alternatively, the handle may be formed as a solid body.

The present invention is by no means limited to the above described preferred embodiments thereof. The rights sought are defined by the claims, within the scope of which many modifications can be envisaged.

Thus, in summary, the wafer boat loader assembly of the invention(2) for loading wafer boats (32) into and unloading wafer boats (32) from a furnace chamber comprises an elongated guide, a carriage, a paddle and a displacement drive (8,18) and a lifting drive (14). The carriage is configured to move along the guide when driven, and the paddle is mounted thereto. The paddle (31) comprises a handle part (28) and a load zone part for carrying a wafer boat (32). The displacement drive (8,18) is configured for moving the carriage along the guide (4) and the lifting drive (14) is configured for tilting the guide (4). Under the load of the wafer boat (32) the paddle (31) will bend through, but this bending may be compensated by means of the drives (8, 18), so that the wafer boat (32) can be placed into the furnace chamber in a horizontal position. Particularly, the use of merely a lifting drive (14) and a displacement drive (8,18) enables that electromotors thereof are heat shielded.

It is observed that this wafer boat loader is particularly suitable for use in furnace systems with a plurality of furnace chambers of the horizontal type stacked above each other, each of them provided with a wafer boat loader assembly. Suitably, the number of furnace chambers is at least four and more particularly at least five. One further advantage of the wafer boat loader assembly of the present invention is that it allows quicker unloading without the need of ramping down the furnace chamber entirely so as to avoid damage to the wafers. Furthermore, the wafer boat may be moved into and within the furnace chamber very precisely, so that the height, which is typically equal to the diameter, of the furnace chamber can be kept small. Particularly, the space left between the wafer boat and a top side of the furnace chamber may be less than 40%, preferably less than 30% or even less than 20% of a size of the wafer. This size is herein specified as the diagonal of the wafer. With a conventional wafer size of 6 inch, the diagonal is about 21 cm. This is particularly achieved by the present configuration that is based on the insight that the paddle may be configured to act as a hinge rather than an entirely rectilinear movement. The hinge is herein created suitably with a theoretical turning point that lies beyond the proximal end of the paddle. More precisely, the movement of the paddle with the wafer boat can be understood as a movement wherein the deflection angle of the wafer boat changes in the course of the movement. While being positive (upwards) in the beginning, outside the furnace chamber, the effective deflection angle is then reduced to zero or even slightly negative when being arranged in the wafer. Similarly, for unloading the wafer boat, the orientation of the paddle may be changed during the process, from negative to arrange the paddle below the wafer boat in the furnace chamber to positive to ensure that the distal end of the paddle may carry the load of the wafer boat. Thereafter, the entire boat may be lifted and removed from the furnace chamber in a more or less horizontal orientation. In order to arrange so, the wafer boat loader assembly is particularly arranged with control means for controlling the lifting drive and the displacement drive. Suitably, the control means are configured with a software programme that based on an input on the wafer boat and other variables defines the settings over time of the drives and therewith the trajectory of the paddle. Additionally, one or more sensors may be envisaged, such as a sensor for measuring the weight of the wafer boat.

## Claims

1. Wafer boat loader assembly (2) for loading wafer boats (32) into and unloading wafer boats (32) from a furnace chamber, comprising:
- an elongated guide (4) which is tiltable about a horizontal rotation axis;
- a carriage coupled to the guide (4) and configured to move along the guide (4) when driven and provided with a frame (24,26);
- a paddle (31) forming a cantilevered support comprising a proximal handle part (28, 131a) and a distal load zone part (131c) for carrying a wafer boat, wherein the handle part (28, 131a) of the paddle (31) being mounted to the carriage via the frame (24,26), and the paddle (31) extending parallel to the guide (4);
- a displacement drive (8, 18) configured for moving the carriage along the guide (4); and
- a lifting drive (14) connected to the guide (4) and configured for tilting the guide (4) by lifting a distal end thereof relative to a proximal end thereof.

2. Wafer boat loader assembly (2) according to claim 1, wherein the frame (24,26) provides a horizontal spacing between the paddle (31) and the guide (4), and the wafer boat loader assembly further comprises a heat shielding wall (36) which extends along the guide (4) and is arranged between the guide (4) and the paddle (31).

3. Wafer boat loader assembly (2) according to any preceding claim, wherein the guide (4) comprises at its proximal end a joint (12) connecting the guide (4) to a fixed support (10), thus blocking translational movement of the horizontal rotation axis.

4. Wafer boat loader assembly (2) according to any preceding claim, wherein the guide (4) comprises a beam (6) and a guiding shaft (19), the carriage being coupled to the guiding shaft (19) for movement along the guiding shaft (19), and wherein preferably the carriage is coupled to the beam (6) via a roller guide (23).

5. Wafer boat loader assembly (2) according to claim 4, wherein the carriage comprises a guide block (22) suspended on the guiding shaft (19) and suspended on the beam (6) via the roller guide (23) disposed on an opposing side of the beam (6) than the guiding shaft (19).

6. Wafer boat loader assembly (2) according to any preceding claim, wherein the displacement drive (8,18) comprises a drive shaft (8) to which a linear drive nut (16) is coupled, which linear drive nut (16) forms part of the carriage (16, 22).

7. Wafer boat loader assembly (2) according to any preceding claim, wherein the lifting drive (14) is configured to enable both a positive tilting angle as a negative tilting angle with respect to the horizontal plane.

8. Wafer boat loader assembly according to any preceding claim, wherein the paddle (31) is a single-walled paddle having a load zone (131c), wherein a cross sectional profile of the load zone comprises a central supporting section (150-154) defining a channel, each opposing side of which adjoins a substantially vertical section (156), wherein a substantially horizontally extending flange (158) is formed on the bottom end of each of said substantially vertical sections (156).

9. Wafer boat loader assembly (2) according to claim 8, wherein the central supporting section comprises two side walls (152) of the channel, each side wall (152) adjoining a substantially horizontal upper wall (154), wherein each of said substantially horizontal upper walls (154) adjoins a corresponding one of said substantially vertical sections (156).

10. Furnace system for wafers, comprising:
- at least one furnace chamber having an open end for inserting wafer boats; and
- for each of the at least one furnace chamber an associated wafer boat loader assembly (2) according to any preceding claim.

11. Use of the wafer boat loader assembly (2) according to any of the preceding claims for loading and unloading a wafer boat (32) into and from a furnace chamber of a furnace system.

12. Method for operating a wafer boat loader assembly of a furnace system according claim 10, comprising:
- controlling the lifting drive (14) for bringing the paddle (31) in a horizontal position;
- loading a wafer boat (32) onto the paddle (31);
- controlling the lifting drive (14) for increasing the tilting angle of the paddle (31), thereby lifting the wafer boat (32);
- controlling the displacement drive (8,18) for moving the paddle (31) with the wafer boat (32) into the corresponding furnace chamber;
- controlling the lifting drive (14) for decreasing the tilting angle of the paddle (31), thereby lowering the wafer boat (32) onto the bottom of the furnace chamber; and
- controlling the displacement drive (8,18) for moving the paddle (31) out of the furnace chamber.

13. Method according to claim 12, wherein the lifting drive (14) and the displacement drive (8,18) are controlled simultaneously such that the wafer boat (32) is simultaneously lifted and moved horizontally.

14. Paddle (31) for a wafer boat (32), wherein said paddle (31) is a single-walled paddle having a load zone (131c), wherein a cross sectional profile of the load zone (131c) comprises a central supporting section (150-154) defining a channel, each opposing side of which adjoins a substantially vertical section (156), wherein a substantially horizontally extending flange (158) is formed on the bottom end of each of said substantially vertical sections (156).

15. Paddle (31) according to claim 14, wherein the central supporting section comprises two side walls (152) of the channel, each side wall (152) adjoining a substantially horizontal upper wall (154), wherein each of said substantially horizontal upper walls (154) adjoins a corresponding one of said substantially vertical sections (156).
